Europäisches Patentamt

European Patent Office

Office européen des brevets

(11) Publication number: **0 153 807**
**B1**

## (12) EUROPEAN PATENT SPECIFICATION

(45) Date of publication of patent specification: **05.04.89**

(51) Int. Cl.⁴: **G 11 B 7/24**

(21) Application number: **85300471.1**

(22) Date of filing: **24.01.85**

(54) **Optical information recording methods.**

(30) Priority: **26.01.84 JP 12431/84**

(43) Date of publication of application:
**04.09.85 Bulletin 85/36**

(45) Publication of the grant of the patent:
**05.04.89 Bulletin 89/14**

(84) Designated Contracting States:
**DE FR GB NL**

(56) References cited:
**FR-A-2 180 711**
**FR-A-2 252 609**
**JP-A-56 163 528**

**PATENTS ABSTRACTS OF JAPAN, vol. 6, no. 260 (M-180)1138r, 18th December 1982; & JP-A-57 152 998 (FUJITSU K.K.) 21-09-1982**

**JOURNAL OF APPLIED PHYSICS, vol. 54, no. 3, March 1983, pages 1256-1260, New York, US; K. WATANABE et al.: "New optical recording material for video disc system" Laser Focus, August 1981, pp 47-52**

(73) Proprietor: **SONY CORPORATION**
**7-35 Kitashinagawa 6-Chome Shinagawa-ku Tokyo 141 (JP)**

(72) Inventor: **Watanabe, Kenjiro c/o Sony Corporation**
**Patents Division 7-35, Kitashinagawa 6-chome Shinagawa-ku Tokyo (JP)**
Inventor: **Sakamoto, Susumu c/o Sony Corporation**
**Patents Division 7-35, Kitashinagawa 6-chome Shinagawa-ku Tokyo (JP)**
Inventor: **Akamatsu, Junichi c/o Sony Corporation**
**Patents Division 7-35, Kitashinagawa 6-chome Shinagawa-ku Tokyo (JP)**

(74) Representative: **Thomas, Christopher Hugo D Young & Co 10 Staple Inn London WC1V 7RD (GB)**

## Description

This invention relates to optical information recording methods using a laser beam.

Photo-magnetic material such as TbFe or GdCo is known as an erasable optical recording material. In an information recording medium using such photo-magnetic material, however, the recorded information, that is, the direction of magnetization, must be read using light polarization, making the optical system quite complex. Moreover, since the erasing is performed by an external magnetic field, the apparatus is complicated.

French patent specification FR—A—2 180 711 discloses a method where reversible phase transition from an amorphous state to a crystalline state or from the crystalline state to the amorphous state is utilized for recording and erasing information. The phase transformation from the crystalline state to the amorphous state is performed by rapid heating and rapid cooling so as to record the information. The phase transition from the amorphous state to the crystalline state is performed slowly so as to carry out erasing. Signal reproduction is performed utilizing the variation of reflectivity R and transmitivity $\tau$ in the amorphous state and the crystalline state. In this method, since the phase transition in the crystalline state to and from the amorphous state is performed by laser light, the intensity and irradiation time of which differ so as to perform the recording and erasing, the method is more advantageous in that the optical system is simplified. In such a recording method utilizing a phase transition, since the reproduced signal level is quite large compared to that produced by photo-magnetic material as above described, this method is also advantageous in that recording with a large contrast ratio is possible. Chalcogenide compounds, mainly TeGeAs are proposed therefore.

Materials containing Se or low-grade oxides of Te are known for use as such recording materials exibiting phase transition. Among these materials, $Sb_2Se_3$ exibits a phase transition from its amorphous state to the crystalline state at about 170°C and therefore the information recording medium utilizing reversibility in the crystalline to and from the amorphous state of this material is possible. The recording material consisting of $Sb_2Se_3$ can be transferred from its amorphous state to its crystalline state by irradiation by a laser beam locally heating this portion to 170°C or more. Since the transition from the amorphous state to the crystalline state must be performed by holding the temperature to 170°C or more for a certain period of time, slow heating conditions utilizing the laser beam are necessary. Transition from the amorphous state to the crystalline state is performed by increasing the quantity of irradiation from the laser beam and heating the material to a melting temperature of about 600°C. In this case, rapid cooling is necessary for the transition to the amorphous state. To summarize, the transition from the amorphous state to the crystalline state is performed by slow heating and slow cooling, while the transition from the crystalline state to the amorphous state is performed by rapid cooling so as to erase and record the information.

In actual practice, however, the transition from the crystalline state to the amorphous state may not be completely effective in such recording material. This is because even if a portion of the material in the crystalline state is melted by irradiation by the laser beam, it is recrystallized in the cooling process.

Journal of Applied Physics 54(3), March 1983, pages 1256 to 1260 discloses a recording method using an SbSe compound. The compound used is $Sb_2Se_3$ and only a slight shift from this atomic ratio in the direction of an Sb-rich composition is envisaged. Japanese patent specification JP—A—56-163 528 is also of slight interest in that it shows variation of irradiation time of a chalcogen compound recording film by controlling rotation of a disc bearing the film.

According to the present invention there is provided a method of recording and erasing information, the method comprising providing a recording medium having a thin film recording layer of an Se compound, heating said layer by means of a laser beam above a crystallizing temperature $T_x$, but below the melting temperature $T_M$ for a time $t_a$ which is greater than a time $t_o$ required for crystallization until the material crystallizes, and transforming the crystallized material into amorphous material by heating to a temperature higher than the melting temperature $T_M$ with a laser beam, and cooling within a time $t_b$ shorter than the time $t_o$, one of the two kinds of heating being in accordance with the intelligence to be recorded whereby an optical information bit is formed by the crystallization or by the transformation to the amorphous state, characterized in that: said layer is composed of an SbSe compound containing from 58 to 85 atomic % Sb.

In a method according to the present invention, utilizing an SbSe compound, a thin film of the compound provides a recording layer in an amorphous state and is applied onto a substrate. It is then heated entirely or only along a recording track portion by selective heating, for example, by means of laser beam irradiation to put it into its crystallized form. Then the crystalline state is transferred into the amorphous state by local heating using a semiconductor laser beam typically having a wavelength of 830 nm. The modulated laser beam thereby forms an optical information bit. This bit can be erased, for example, by irradiating along the recording track with the laser beam so that the amorphous part is recrystallized. In the transition from the amorphous state to the crystalline state, the heating temperature T is higher than the crystallizing temperature $T_x$ of the recording layer material and lower than its melting temperature $T_M$. The following relationship therefore applies:

$T_x$ is less than T is less than $T_M$.

If the time for which the material is held at the temperature T under these conditions is represented by $t_a$, the time $t_a$ must be longer than the time required for crystallization. That is, the following condition applies:

$$t_a \text{ is greater than } t_o \qquad (1)$$

On the other hand, the transition from the crystalline state to the amorphous state is effected by heating to a temperature higher than the melting temperature $T_M$ and cooling. If the time required for cooling from the melting temperature $T_M$ to the crystallizing temperature $T_x$ is represented by $t_b$, the time $t_b$ must be shorter than the time $t_o$ required for crystallization. In other words, the following relationship obtains:

$$t_o \text{ is greater than } t_b \qquad (2)$$

Consequently, in order to secure both transitions in the amorphous state to and from the crystalline state, the following relationship is required:

$$t_a \text{ is greater than } t_o \text{ is greater than } t_b \qquad (3)$$

Embodiments of the invention provide methods wherein the above equation (3) can be achieved easily and certainly, and transition of the recording layer in the crystalline state to and from the amorphous state, that is, for recording and erasing of information, can be effected easily.

The invention will now be described by way of example with reference to the accompanying drawings, in which:

Figure 1 is a curve plotting reflectivity against Sb content in the SbSe compounds in the amorphous state and in the crystalline state;

Figures 2 and 3 are curves illustrating plots of detecting element output versus reflectivity for various compositions; and

Figure 4 is a curve plotting the relationship between reflectivity and the film thickness of the SbSe compound.

Methods according to the present invention use a thin film recording layer composed of SbSe containing Sb in an amount of 58 to 85 atomic %, and preferably including Sb in an amount of 68 to 77 atomic %, the balance being Se, on a substrate. Information is recorded thereon by light irradiation.

If the amount of Sb is less than 68 atomic %, and particularly less than 58 atomic %, the time $t_o$ required for crystallization is so long that the condition set forth in equation (1) cannot be satisfied, and the transition from the amorphous state to the crystalline state cannot be produced. On the other hand, if the Sb content is more than 77 atomic %, and particularly more than 85 atomic %, the crystallizing time $t_o$ becomes so short that although the conditions of equation (1) can easily be satisfied, the conditions of equation (2) cannot be satisfied, even if the transition from the crystalline state to the amorphous state is intended, since the recrystallized material resists returning to its amorphous state.

Moreover, if the Sb content becomes excessive, crystal separation of a part of the Sb is produced when forming the thin film, and moreover the diameters of crystal particles produced by heating using laser ray irradiation become large. This presents no problem if the laser beam diameter is 5 to $6 \times 10^{-2}$ mm, but noise may be produced during signal reproduction if the laser beam diameter is about $1 \times 10^{-3}$ mm.

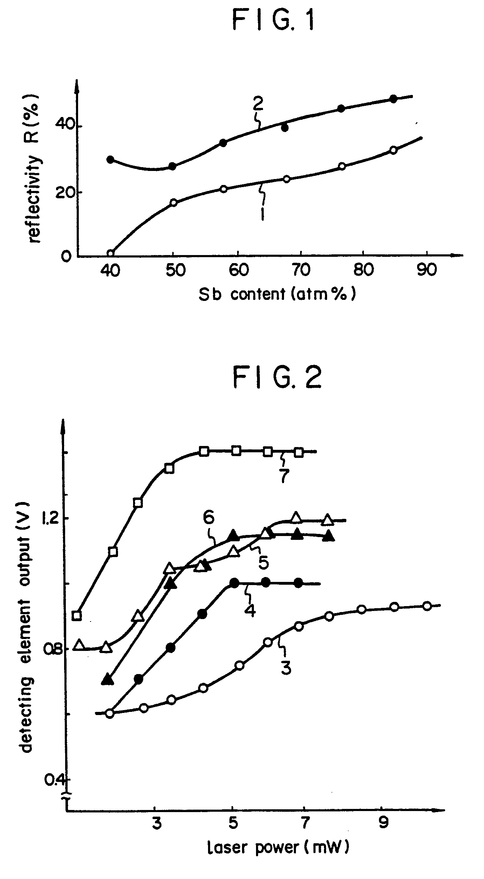

Figure 1 shows the results obtained when a thin film recording layer of SbSe compound having a thickness of 8 to $11 \times 10^{-5}$ mm is evaporated on a transparent acrylic substrate, and an acrylic plate is disposed on the thin film recording layer. The Sb content in the recording layer is varied between specimens, and the reflectivity R of the specimens was measured when the SbSe recording layer was in the amorphous state and when the layer was heated and cooled slowly into crystallization. In Figure 1, curve 1 illustrates the reflectivity R obtained in the amorphous state and curve 2 shows the reflectivity in the crystalline state. It can be clearly seen from the curves 1 and 2 that when the Sb content is varied, there is a difference of reflectivity R between the amorphous state and the crystalline state and that it can become large.

Figure 2 shows the results obtained where various discs having SbSe thin film recording layers in their amorphous state but differing in composition were prepared and rotated at rotational speeds of 300 rpm, with a laser beam being irradiated onto each disc using varying amounts of laser power, and then the reflectivity with respect to a semiconductor laser beam was measured by means of the reproduction output of a light detecting element. In Figure 2, curve 3 shows the results obtained using $Sb_{68}Se_{32}$, curve 4 used $Sb_{71}Se_{29}$, curve 5 used $Sb_{73}Se_{27}$, curve 6 used $Sb_{77}Se_{23}$, and curve 7 used $Sb_{81}Se_{19}$. It can be clearly seen from the curves 4 to 7 that as the Sb content becomes large, the transition from the amorphous state to the crystalline state with a large variation of reflectivity is obtained at low power levels.

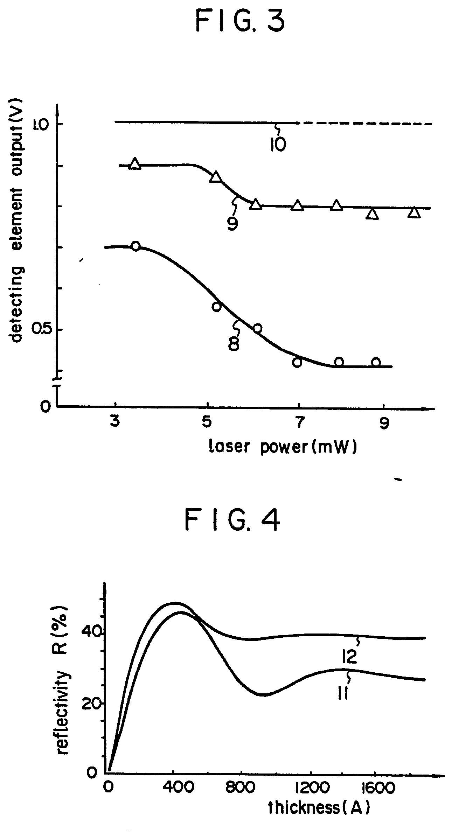

Figure 3 shows the results obtained when a thin film of SbSe compound with different composition ratios was evaporated on a glass substrate and then heated and cooled slowly into complete crystallization. Each specimen had a thin film recording layer treated in such a manner in the form of a disc which was rotated at a rotational speed of 300 rpm. A semiconductor laser beam was irradiated onto the disc when the laser power on the disc surface was varied. Then, the reflectivity of the irradiated part with respect to the semiconductor laser was measured by means of the reproduction output of a light detecting element. In Figure 3, curve 8 shows the results obtained using a thin film recording layer of $Sb_{58}Se_{42}$, and curve 9 used $Sb_{68}Se_{32}$. Curve 10

shows that the compound $Sb_{81}Se_{19}$ represents a condition where the recording layer is so deformed that variation of optical properties, that is, variation of reflectivity, cannot be detected. It will be understood from the curves 8 to 10 that the smaller the Sb content, the more the reflectivity variation which exists by the transition from the crystalline state to the amorphous state.

It can be clearly seen from Figures 2 and 3 that, in the case of an SbSe compound recording layer, reversible transition between the amorphous state and the crystalline state can be performed readily at certain ranges of Sb content. Although a disc rotation speed of 300 rpm was used in making these measurements, if it is raised to 1800 rpm, for example, the cooling time $t_b$ can be substantially decreased. This is because when the laser transferring speed is rapid the heat storage effect is decreased and the cooling rate becomes rapid. In fact, transition of $Sb_{81}Se_{19}$ from the crystalline state to the amorphous state is difficult at 300 rpm but is possible at 1800 rpm. In other words, even if the film crystallizing time $t_o$ is the same, the above-mentioned relationship shown in equation (1) can be satisfied by varying the disc rotation speed.

In the other situation, the disc rotation speed may be decreased for the transition from the amorphous state to the crystalline state, or when the reversible transition in the amorphous state to and from the crystalline state is performed at the same disc rotation speed, the beam spot of the irradiating laser beam may be made in elliptical form only at the transition from the amorphous state to the crystalline state, whereby the time $t_a$ can be substantially increased and the condition specified in equation (2) can be satisfied. From the foregoing, it is concluded that the Sb content to satisfy equation (3) should be 58 to 85 atomic %.

### Example

On an acrylic substrate having a thickness of 1.2 mm a guide groove was moulded by injection moulding. A film of $SiO_2$ having a thickness of $15 \times 10^{-5}$ mm was evaporated into the groove by electron beam evaporation. A thin film recording layer of $Sb_{70}Se_{30}$ film was formed on the $SiO_2$ film. The SbSe thin film recording layer was formed to a thickness of about $9 \times 10^{-5}$ mm using both an $Sb_2Se_3$ evaporation source and an Sb evaporation source and controlling the evaporation rate of both sources to provide coevaporation. Then, on the $Sb_{70}Se_{30}$ thin film recording layer there was further evaporated an $SiO_2$ film to a thickness of $12 \times 10^{-5}$ mm, and an acrylic plate having a thickness of 1.2 mm was closely contacted with the $SiO_2$ film and cured using an ultraviolet setting resin. The purpose of forming the $SiO_2$ films with the interposition of the thin film recording layer is that when the laser beam is focused and irradiated on the thin film recording layer and local heat is effected, the acrylic substrate is prevented from thermal deformation and irreversible reaction by thermal deformation is avoided. A semiconductor laser beam was irradiated onto the disc of a diameter of 200 mm produced in such a manner from the side of the substrate and erasing of the record was performed.

First, a part of the thin film recording layer formed in amorphous state and to be made part of a recording track was crystallized at a disc rotation speed of 450 rpm. The power of the semiconductor laser on the disc surface was 11 mW. Next, the track crystallized in this manner was transferred from the crystalline state to the amorphous state at a disc rotation speed of 1800 rpm. A laser power modulation frequency of 2 MHz was used to perform the recording. The peak power was 15 mW on the disc surface. A good optical recording bit was formed. The same track was crystallized again at 450 rpm and the signal erasing was confirmed. The power of the semiconductor laser was 11 mW on the disc surface as in the previous crystallization.

Figure 4 shows the results obtained when the film thickness of a thin film recording layer of $Sb_{68}Se_{32}$ formed on a glass substrate was varied. Curve 11 in Figure 4 shows the reflectivity R of the thin film recording layer in the originally formed amorphous state with respect to the semiconductor laser ray. Curve 12 illustrates the reflectivity R of the recording layer in the crystalline state created by heating and slow cooling. It will be seen from Figure 4 that if the thickness of the recording layer is made $85 \times 10^{-5}$ mm or more, even at a single layer, there is a large variation of the reflectivity obtained between the amorphous state and the crystalline state irrespective of the film thickness. In this case, the complex refractive index n in the amorphous state is $\hat{n} = 4.4 - 1.5\,i$, and n in the crystalline state is $\hat{n} = 4.9 - 2.8\,i$.

Although the foregoing description relates mainly to recording in the crystalline state to the amorphous state and erasing in the amorphous state to the crystalline state, the recording and the erasing may be reversed. The invention can also be applied not only to a rotatable disc, such as an audio or video disc, but also to a recording medium in card form.

### Claims

1. A method of recording and erasing information, the method comprising providing a recording medium having a thin film recording layer of an Se compound, heating said layer by means of a laser beam above a crystallizing temperature $T_x$, but below the melting temperature $T_M$ for a time $t_a$ which is greater than a time $t_o$ required for crystallization until the material crystallizes, and transforming the crystallized material into amorphous material by heating to a temperature higher than the melting temperature $T_M$ with a laser beam, and cooling within a time $t_b$ shorter than the time $t_o$, one of the two kinds of heating being in accordance with the intelligence to be recorded whereby an optical information bit is formed by the crystallization or by the transformation to the amorphous state, characterized in that: said layer is composed of an SbSe compound containing from 58 to 85 atomic % Sb.

2. A method according to claim 1 wherein said recording layer is on a disc which is rotated at a lower speed during crystallization than when recording in the amorphous state.

3. A method according to claim 2 which includes the step of recording by the transformation to the amorphous state and the step of erasing the recording by reverting said recording layer to the crystallized state.

4. A method according to claim 1, claim 2 or claim 3 wherein said compound contains 68 to 77 atomic % Sb.

5. A method according to any one of the preceding claims wherein a layer of $SiO_2$ is interposed between a substrate and said compound.

6. A method according to any one of the preceding claims wherein said recording layer is 8 to $11 \times 10^{-5}$ mm in thickness.

**Patentansprüche**

1. Verfahren zum Aufzeichnen und Löschen von Informationen, wobei das Verfahren enthält:

Bereitstellen eines Aufzeichnungsträgers mit einer Dünnfilm-Aufzeichnungsschicht aus einer Selenverbindung,

Erhitzen der Schicht mit einem Laserstrahl auf eine Temperatur, die oberhalb einer Kristallisationstemperatur $T_x$, aber unterhalb der Schmelztemperatur $T_M$ liegt, während einer Zeitdauer $t_a$, die größer ist als die zur Kristallisation benötigte Zeitdauer $t_o$, bis der Werkstoff kristallisiert und

Umwandeln eines kristallisierten Werkstoffes in einen amorphen Werkstoff durch Erhitzen mit einem Laserstrahl auf eine Temperatur, die höher ist als die Schmelztemperatur $T_M$, und

Abkühlen innerhalb einer Zeitdauer $t_b$, die kürzer ist als die Zeitdauer $t_o$,

wobei eine der zwei Erhitzungsarten in Übereinstimmung gemäß dem Informationsgehalt, der aufgezeichnet werden soll, steht, so daß ein optisches Informationsbit durch die Kristallisation oder durch die Umwandlung in den amorphen Zustand gebildet wird, dadurch gekennzeichnet daß die Schicht aus einer SbSe-Verbindung, die 58 bis 85 Atom-% Sb enthält, zusammengesetzt ist.

2. Verfahren gemäß Anspruch 1, bei dem die Aufzeichnungsschicht auf einer runden Scheibe ist, die während Kristallisation bei einer niedrigeren Geschwindigkeit gedreht wird als bei der Aufzeichnung im amorphen Zustand.

3. Verfahren gemäß Anspruch 2, wobei das Verfahren den Aufzeichnungsschritt: Umwandlung in den amorphen Zustand und den Löschungsschritt der Aufzeichnung: Umkehrung dieser Aufzeichnungsschicht in den kristallisierten Zustand einschließt.

4. Verfahren gemäß den Ansprüchen 1, 2 oder 3, bei dem die SbSe-Verbindung 68 bis 77 Atom-% Sb enthält.

5. Verfahren gemäß einem beliebigen der vorhergehenden Ansprüche, bei dem eine Schicht aus $SiO_2$ zwischen einem Substrat und dieser SbSe-Verbindung eingeschoben ist.

6. Verfahren gemäß einem beliebigen der vorhergehenden Ansprüche, bei dem die Aufzeichnungsschicht eine Dicke von 8 bis $11 \times 10^{-5}$ mm hat.

**Revendications**

1. Procédé d'enregistrement et d'effacement d'information, le procédé consistant à produire un support d'enregistrement qui comporte une couche d'enregistrement en pellicule mince d'un composé de Se, à chauffer ladite couche au moyen d'un faisceau laser au-dessus de la température de cristallisation $T_x$, mais au-dessous de la température de fusion $T_M$, pendant une durée $t_a$ qui est supérieure à la durée $t_o$ nécessaire pour atteindre la cristallisation du matériau, et à transformer le matériau cristallisé en matériau amorphe en chauffant à une température supérieure à la température de fusion $T_M$ à l'aide d'un faisceau laser, et en refroidissant en un temps $t_b$ plus court que le temps $t_o$, l'un des deux types d'échauffement étant en rapport avec des informations à enregistrer si bien qu'un bit d'information optique est formé par la cristallisation ou par la transformation dans l'état amorphe, caractérisé en ce que: ladite couche est constituée d'un composé de SbSe contenant de 58 à 85 atomes % de Sb.

2. Procédé selon la revendication 1, où ladite couche d'enregistrement se trouve sur un disque qui, pendant la cristallisation, est entraîné en rotation à une vitesse inférieure à celle utilisée pendant l'enregistrement dans l'état amorphe.

3. Procédé selon la revendication 2, qui comporte l'opération consistant à enregistrer par une transformation conduisant à l'état amorphe et l'opération consistant à effacer l'enregistrement par un retour de la couche d'enregistrement à l'état cristallin.

4. Procédé selon la revendication 1, 2 ou 3, où ledit composé contient de 68 à 77 atomes % de Sb.

5. Procédé selon l'une quelconque des revendications précédentes, où une couche de $SiO_2$ s'interpose entre un substrat et ledit composé.

6. Procédé selon l'une quelconque des revendications précédentes, où ladite couche d'enregistrement a une épaisseur de 8 à $11 \times 10^{-5}$ mm.

# F I G. 1

# F I G. 2

# F I G. 3

# F I G. 4